# EUROPÄISCHE PATENTSCHRIFT

(11) **EP 2 502 255 B1**
(45) Veröffentlichungstag und Bekanntmachung des Hinweises auf die Patenterteilung: **23.04.2014**
(21) Anmeldenummer: 10768183.5
(22) Anmeldetag: 05.10.2010
(51) Int. Cl.: H01J 37/32, H01L 21/00

(54) **TEILSPULENSYSTEM ZUR SIMULATION VON KREISSPULEN FÜR VAKUUMVORRICHTUNGEN**
COIL SECTION ASSEMBLY FOR SIMULATING CIRCULAR COILS FOR VACUUM DEVICES
SYSTÈME DE BOBINES PARTIELLES POUR SIMULER DES BOBINES CIRCULAIRES POUR DES DISPOSITIFS SOUS VIDE

(30) Priorität: 20.11.2009 US 262965 P
(43) Veröffentlichungstag der Anmeldung: 26.09.2012
(73) Patentinhaber: Oerlikon Trading AG, Trübbach, 9477 Trübbach (CH)
(72) Erfinder: KRASSNITZER, Siegfried, A-6800 Feldkirch (AT)
(74) Vertreter: Kempkens, Anke
(86) Internationale Anmeldenummer: PCT/EP2010/006067
(87) Internationale Veröffentlichungsnummer: WO 2011/060847

(56) Entgegenhaltungen:
- WO-A1-95/15672
- WO-A1-97/02588
- US-A1- 2006 102 077

## Beschreibung

Die vorliegende Erfindung bezieht sich auf ein Magnetsystem für Vakuumanlagen gemäss dem Oberbegriff des Anspruchs 1. Die Erfindung betrifft insbesondere Beschichtungsanlagen mit Magnetsystem zur Steuerung von Plasmaeigenschaften.

Zur Steuerung der Plasmaeigenschaften in Beschichtungsanlagen werden unter anderem Magnetsysteme zur Erzeugung von Magnetfelder verwendet. Die Magnetfeldlinien und Magnetfeldstärken sollen dabei im Beschichtungsraum bzw. am Substrat so homogen wie wirtschaftlich möglich verteilt sein. Eine wichtige Methode zur Erzeugung von Magnetfeldern ist die Anbringung von Spulen, insbesondere in einer Helmholtzanordnung.

In WO9515672 von Shohet wird beispielweise eine Spulenanordnung zur Erzeugung eines gleichmässigen, planaren Plasmas offenbart, die zwei planare Hochfrequenzspulen zur Erzeugung eines Induktionsfeldes umfasst. Wahlweise können die Hochfrequenzspulen aus getrennten Teilwindungen bestehen, um zugeschnittene Induktionsfelder zu produzieren, die bestimmte räumliche Verteilungen des Plasmas ermöglichen können.

In W09702588 von Gates wird im Allgemeinen eine Spule mit niedriger Induktivität und grosser Fläche für eine induktiv gekoppelte Plasmaquelle offenbart, die im Besonderen zur Erzeugung eines Plasmas zum Behandeln von Halbleiterwafern in Niederdruckanlagen geeignet sein kann.

Speziell in grossen Batch Anlagen mit Frontbeladung ist ein praktikables Anbringen von Spulen in z.B. Helmholzanordnung baulich sehr schwierig, da dies beim Öffnen der Türe überstehen und beim Be- und Entladevorgang im Weg stehen.

Eine Möglichkeit diese Schwierigkeit zu umgehen ist es von der Frontbeladung auf die Boden- und/oder Topbeladung überzugehen. Demgemäss wird in US 5250779 von Kaufmann et al. wird eine Beschichtungsanlage und im Speziellen ein Heizprozess über ein Plasma angegeben, wobei die Substrate als Anode der Plasmaquelle geschaltet sind. Die Plasma- und damit die Heizleistungsverteilung werden über ein paar Helmholzspulen gesteuert. Hierbei erfolgt die Beladung der Kammer mit Substraten über das Konzept "Bodenlader", d.h. parallel zu den Spulenachsen und durch die untere Spule hindurch. Hierbei kommt es daher nicht zu einer Kollision mit den Helmholzspulen. In ähnlicher Weise können sogenannte Toplader realisiert werden, bei denen von oben beladen wird.

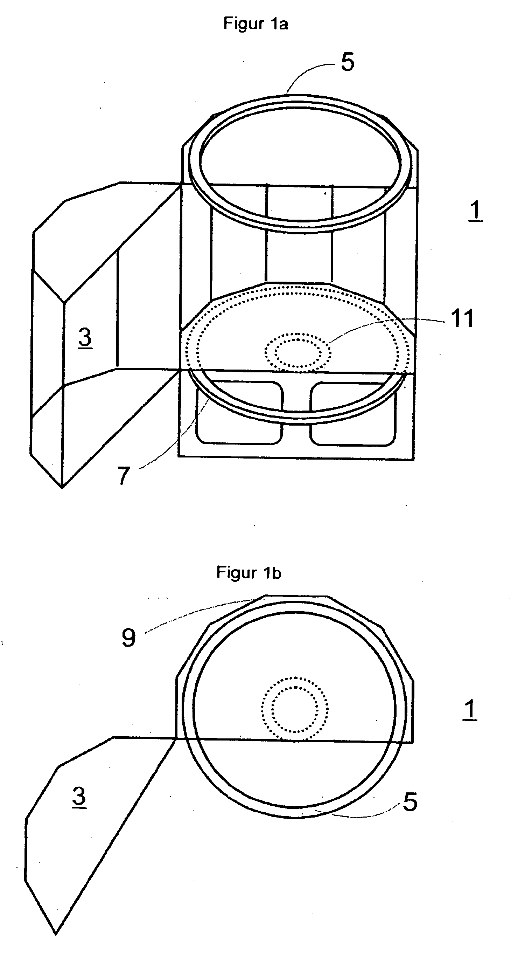

Will man allerdings nicht auf das Konzept des Frontladers verzichten, so ist man mit den oben bereits genannten Schwierigkeiten konfrontiert, die mit Figur 1 noch etwas mehr veranschaulicht werden sollen. Gezeigt ist die perspektivische Ansicht (Figur 1 a) sowie die Draufsicht (Figur 1 b) einer Beschichtungsanlage 1 mit offener Fronttüre 3. Es handelt sich daher hierbei um einen Frontlader. Dass Helmholtzspulenpaar 5, 7 sollte nahezu den Durchmesser der Beschichtungskammer 9 einnehmen um in der Kammer das benötigte homogene Feld zu Verfügung zu stellen. Dabei ist die Spule 5 oberhalb der eigentlichen Kammer angeordnet und die Spule 7 unterhalb der Kammer angeordnet. Wie aus der Figur 1 deutlich hervorgeht, bildet die Spule 7 für das Be- und Entladen ein grosses Hindernis, da nicht bis an den Kammerrand herangefahren werden kann.

In der Figur 1 ebenfalls angedeutet ist eine mögliche Lösung des Problems, wie sie in US20060102077 von Esselbach et al. beschrieben ist. Als Lösung wird hier eine im Verhältnis zur optimalen Helmholzanordnung sehr keine untere Spule 11 vorgeschlagen. Hier stört die Spule zwar nicht mehr beim Ladevorgang, allerdings ist die damit erzielbare Magnetfeldverteilung innerhalb der Kammer weit vom Optimum entfernt.

Gemäss einem anderen Lösungsansatzes wird für die untere Spule eine Spule vorgeschlagen, deren Windungen an bestimmten Stellen als bewegliche Litzen ausgeführt sind. Dadurch ist es möglich ein Segment der Spule beim Beladevorgang der Anlage z.B. nach unten wegzuklappen. Die Herstellung solcher Spulen und insbesondere ihre Wartung ist aber mit erheblichem Aufwand verbunden. So muss gewährleistet, dass über die beweglich auszuführenden Teile ein grosser Stromfluss weitgehend ungehindert fliessen kann. Zudem muss für den nach unten zu klappender Teil wiederum in dem Bereich der Be- und Entladung Platz vorgesehen werden, wobei hier zu beachten ist, dass die hierbei zum Einsatz kommenden Spulen eine erhebliche Dicke aufweisen.

Es besteht daher das Bedürfnis nach einer als Frontlader ausgelegten Vakuumbehandlungsanlage mit Spulenanordnung welche die Probleme des Stand der Technik überwindet.

Es ist daher Aufgabe der vorliegenden Erfindung eine gegenüber dem Stand der Technik verbesserte, als Frontlader ausgelegte Vakuumbehandlungsanlage mit Spulenanordnung anzugeben, bei der im Besonderen das Be- und Entladen der Substrate durch die Spulenanordnung nicht behindert wird.

Erfindungsgemäss wir die Aufgabe dadurch gelöst, dass zumindest eine der Spulen eines Helmholzspulenpaares aus mindestens zwei nebeneinander liegenden Teilspulen realisiert wird. Die zumindest eine Spule umfasst also zumindest eine erste Teilspule und eine zweite Teilspule, wobei erste und zweite Teilspule im Querschnitt nebeneinander vorzugsweise in einer Ebene liegen. Der Begriff "nebeneinander" ist in diesem Zusammenhang so zu verstehen, dass zumindest jeweils ein Teilabschnitt der ersten Spule im Wesentlichen dem Verlauf eines Teilabschnitts der zweiten Spule folgt, wobei der Abstand des ersten Teilabschnittes vom zweiten Teilabschnitt mindestens eine Grössenordnung kleiner als der Querschnitt der gegebenenfalls kleineren Teilspule ist. Als kleinere Teilspule wird diejenige Teilspule bezeichnet, die gegebenenfalls einen kleineren Querschnitt hat. Eine solche Konfiguration der unteren Spule eröffnet die Möglichkeit durch erste und zweite Teilspule Strom derart fliessen zu lassen, dass die Stromrichtungen in den nebeneinander liegenden Teilabschnitten gegenläufig sind und sich damit in Bezug auf das entstehende Magnetfeld der Gesamtspule aufheben. Bei der Vakuumbehandlungskammer handelt es sich gemäss der vorliegenden Erfindung um eine solche mit Fronttüre, so dass die erste Teilspule an der Fronttüre angeordnet ist und mit derselben von der Kammer weggeklappt werden kann.

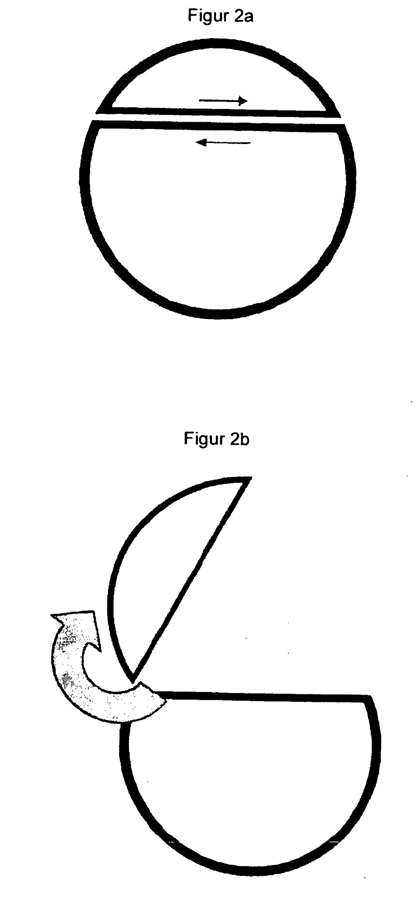

Figur 2a zeigt schematisch eine solche aus erster und zweiter Teilspule zusammengesetzten Spulenkonfiguration. Die Pfeile deuten die Stromrichtungen im Betrieb an. Das ergibt resultierend im Wesentlichen das Magnetfeld einer kreisrunden Spule der besondere Vorteil an dieser Konfiguration liegt darin, dass die erste Teilspule von der zweiten Teilspule elektrisch entkoppelt ist, d.h. keinen gemeinsamen Stromkreis mit ihr bildet und daher in einfacher Weise gegenüber der zweiten Teilspule mechanisch beweglich montiert werden kann. In Figur 2b ist eine Ausführungsform gezeigt, gemäss der die erste Teilspule um eine Achse parallel zur Achse des Helmholzspulenpaares weggeklappt wurde. Oftmals ist diese Achse parallel zur Achse der Fronttüre, so dass die erste Teilspule beispielsweise unter der Türe montiert werden kann und mit derselben weggeklappt werden kann.

Elektrische spulen können generell durch Aufwickeln von elektrisch leitendem Draht auf einen Wickelkörper hergestellt werden. In der Regel wird als Drahtmaterial Kupfer mit einer Tauchlackisolation verwendet. Nachteile sind das hohe Gewicht und die erheblichen kosten für den Kupferdraht und den Wickelkörper. Bei Verwendung von kostengünstigerem Runddraht ist die Packungsdichte des Drahtes mit üblicherweise kleiner 60% gering. Es resultiert eine schlechte Ableitung der Verlustwärme die zusammen mit der Verwendung von Isolationslacken eine Limitierung der magnetischen Leistung der Spule bedeutet.

Als Alternative hat sich die Herstellung von Spulen durch Aufwickeln von Aluminiumbänden erwiesen. Dabei werden eloxierte Aluminiumbänder zu einer Spule aufgewickelt. Die Isolation wird durch die Aluminiumoxidschicht gewährleistet. Solche Spulen werden mit Epoxydharz vergossen, so dass diese eine in sich stabile mechanische Konstruktion darstellen hierdurch können Packungsdichten des Leitermaterials von bis zu 98% erreicht werden. Ein weiterer günstiger Effekt ist die geringe Masse solcher Aluminiumbandspulen welche zusammen mit der guten mechanischen Stabilität auf einfache weise angebaut werden können.

Die Erfindung wird nun im detail und anhand von mehreren Ausführungsformen mit Hilfe der Figuren genauer erläutert.

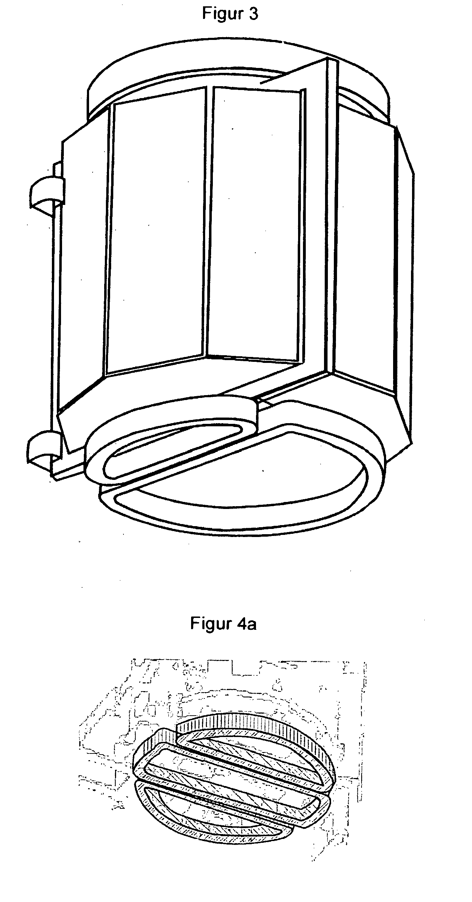

Figur 3 zeigt perspektivisch das Gerüst einer eintürigen Vakuumbehandlungsanlage mit einer ersten Ausführungsform einer erfindungsgemässen Spulenkonfiguration. Im unteren Bereich ist die erste Teilspule deutlich sichtbar, die unten an die Türe montiert ist sowie die zweite Teilspule, welche unter dem Rest der Anlage montiert ist.

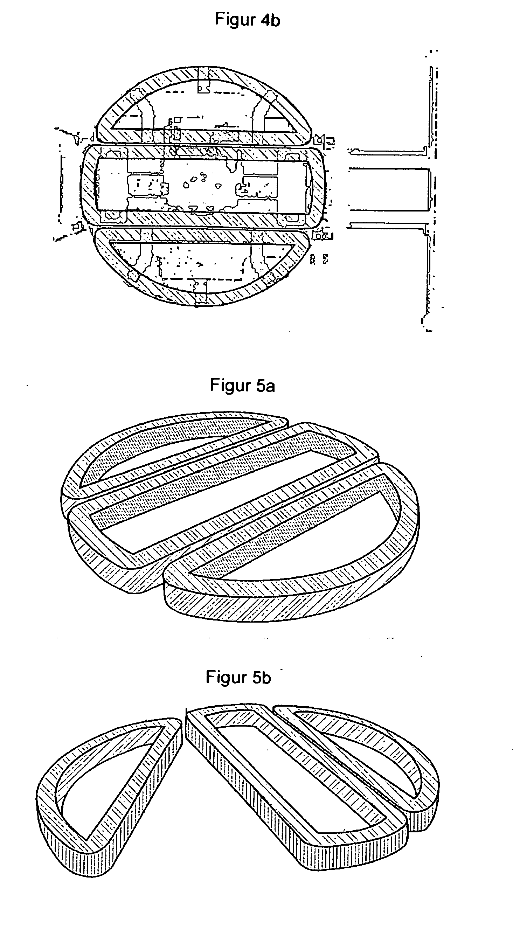

Figuren 4a und 4b zeigen eine Ausführungsform welche Teilauschnitte einer Beschichtungsanlage zeigt, welche unter dem Namen Oerlikon Balzers RS 90 bekannt ist und erfindungsgemäss modifiziert wurde. Diese Anlage hat zwei Türen: eine für die Substratbeladung, die andere für die Maschinenwartung. Eine dem Kammerumfang im Wesentlichen entsprechende kreisförmige Spule wird in dieser Ausführungsform durch drei Einzelspulen simuliert, deren gemeinsamer Umfang einen Kreis ergibt. Figur 4a zeigt die Teilspulenkonfiguration an der Anlage in perspektivischer Seitenansicht. Figur 4b zeigt die Teilspulenkonfiguration an der Anlage in der "Draufsicht" von unten. Figuren 5a und 5b zeigen die drei einzelnen Teilspulen. Deutlich zu sehen ist die sowohl elektrische als auch mechanische Entkoppelung der Einzelspulen. Figur 5a simuliert den Zustand bei geschlossener Kammer, Figur 5b simuliert den Zustand bei offener Kammer.

Es wurde Vakuumbehandlungskammer mit Spulenanordnung zum Aufbau eines magnetischen Feldes in der Kammer beschrieben, wobei die Spulenanordnung mindestens eine erste Teilspule und eine zweite Teilspule umfasst, wobei die erste Teilspule und die zweite Teilspule derart im Querschnitt nebeneinander, vorzugsweise in einer Ebene liegen, dass zumindest jeweils ein Teilabschnitt der ersten Spule im Wesentlichen dem Verlauf eines Teilabschnitts der zweiten Spule folgt, wobei der Abstand des ersten Teilabschnittes vom zweiten Teilabschnitt mindestens eine Grössenordnung kleiner als der Querschnitt einer Teilspule und gegebenenfalls der kleineren Teilspule ist.

Bei der Vakuumbehandlungskammer handelt es sich um eine solche mit Fronttüre und die erste Teilspule ist an der Fronttüre angeordnet und kann mit derselben von der Kammer weggeklappt werden.

Die Spulenanordnung kann eine weitere Spule umfassen und die Spulenanordnung kann eine dem Durchmesser der Kammer im Wesentlichen entsprechende Helmholtz-Spulenanordnung bildet.

Die erste Teilspule muss nicht mit der zweiten Teilspule einen gemeinsamen Stromkreis bilden, sie ist vorzugsweise elektrisch entkoppelt.

Die erste Teilspule kann mechanisch entkoppelt von der zweiten Teilspule an der Behandlungsanlage angeordnet sein.

Die Vakuumbehandlungskammer kann Bestandteil einer Vakuumbehandlungsanlage und insbesondere einer Beschichtungsanlage sein.

## Patentansprüche

1. Vakuumbehandlungskammer mit Spulenanordnung zum Aufbau eines magnetischen Feldes in der Kammer wobei die Spulenanordnung mindestens eine erste Teilspule und eine zweite Teilspule umfasst, wobei die erste Teilspule und die zweite Teilspule derart im Querschnitt nebeneinander, vorzugsweise in einer Ebene liegen, dass zumindest jeweils ein Teilabschnitt der ersten Spule im Wesentlichen dem Verlauf eines Teilabschnitts der zweiten Spule folgt, wobei der Abstand des ersten Teilabschnittes vom zweiten Teilabschnitt mindestens eine Grössenordnung kleiner als der Querschnitt einer Teilspule und gegebenenfalls der kleineren Teilspule ist, **dadurch gekennzeichnet, dass** es sich bei der Vakuumbehandlungskammer um eine Vakuumbehandlungskammer mit Fronttüre handelt und die erste Teilspule an der Fronttüre angeordnet ist und mit derselben von der Kammer weggeklappt werden kann.

2. Vakuumbehandlungskammer nach Anspruch 1, **dadurch gekennzeichnet, dass** die Spulenanordnung eine weitere Spule umfasst und die Spulenanordnung eine dem Durchmesser der Kammer im Wesentlichen entsprechende Helmholtz-Spulenanordnung bildet.

3. Vakuumbehandlungskammer nach Anspruch 1 oder 2, **dadurch gekennzeichnet, dass** die erste Teilspule mit der zweiten Teilspule keinen gemeinsamen Stromkreis bildet und vorzugsweise elektrisch entkoppelt ist.

4. Vakuumbehandlungskammer nach einem der vorherigen Ansprüche, **dadurch gekennzeichnet, dass** die erste Teilspule mechanisch entkoppelt von der zweiten Teilspule an der Behandlungsanlage angeordnet ist.

5. Vakuumbehandlungsanlage, insbesondere Beschichtungsanlage welche eine Vakuumbehandlungskammer nach einer der vorherigen Ansprüche umfasst.

## Claims

1. Vacuum treatment chamber with coil arrangement for generating a magnetic field within the chamber, wherein the coil arrangement comprises at least one first coil section und a second coil section, wherein the first coil section and the second coil section are arranged adjacent to each other in cross-section and preferably in one plane, such that at least one respective partial section each of the first coil essentially follows the contour of one partial section of the second coil, wherein the distance between the first partial section and the second partial section is at least one dimension smaller than the cross-section of one coil section and possibly of the smaller coil section, **characterized in that** it is a vacuum treatment chamber with a front door and the first coil section is mounted on the front door and can be tilted together with it away from the chamber.

2. Vacuum treatment chamber according to claim 1, **characterized in that** the coil arrangement comprises another coil and the coil arrangement constitutes a Helmholtz coil arrangement corresponding essentially to the diameter of the chamber.

3. Vacuum treatment chamber according to claim 1 or 2, **characterized in that** the first coil section does not constitute a common electric circuit with the second coil section and is preferably electrically decoupled.

4. Vacuum treatment chamber according to one of the preceding claims, **characterized in that** the first coil section is mounted on the treatment installation in a manner mechanically decoupled from the second coil section.

5. Vacuum treatment installation, especially coating installation comprising a vacuum treatment chamber according to one of the preceding claims.

## Revendications

1. Chambre de traitement sous vide comportant un arrangement de bobines pour générer un champ magnétique dans la chambre, l'arrangement de bobines comprenant au moins une première bobine partielle et une deuxième bobine partielle, la première bobine partielle et la deuxième bobine partielle étant disposées de façon adjacente l'une à côté de l'autre dans la section transversale, préférablement sur un seul niveau de manière que du moins une section partielle respective de la première bobine suit essentiellement l'allure d'une section partielle de la deuxième bobine, la distance entre la première section partielle et la deuxième section partielle étant inférieure d'au moins une dimension à la section transversale d'une bobine partielle et, le cas écheant, de la bobine partielle plus petite, **caractérisé par le fait qu'**il s'agit d'une chambre de traitement sous vide comportant une porte frontale et la première bobine partielle est montée à la porte frontale et peut être basculée avec celle-ci en direction opposée à la chambre.

2. Chambre de traitement sous vide selon la revendication 1, **caractérisé par le fait que** l'arrangement de bobines comprend une autre bobine et l'arrangement de bobines constitue un arrangement de bobines de Helmholtz correspondant essentiellement au diamètre de la chambre.

3. Chambre de traitement sous vide selon la revendication 1 ou 2, **caractérisé par le fait que** la première bobine partielle ne constitue pas un circuit électrique commun avec la deuxième bobine partielle et est decouplée préférablement de façon électrique.

4. Chambre de traitement sous vide selon une des revendications précédentes, **caractérisé par le fait que** la première bobine partielle est montée à l'installation de traitement de façon mécaniquement découplée de la deuxième bobine partielle.

5. Installation de traitement sous vide, particulièrement installation de revêtement comprenant une chambre de traitement sous vide selon une des revendications précédentes.
